# EUROPÄISCHE PATENTANMELDUNG

(11) **EP 2 620 988 A1**
(43) Veröffentlichungstag der Anmeldung: **31.07.2013**
(21) Anmeldenummer: 12152713.9
(22) Anmeldetag: 26.01.2012
(51) Int. Cl.: H01L 33/00, H01L 33/56, H01L 31/0203

(54) **Transparente Polyurethane als Einbettung für opto-elektronische Bauteile**

(71) Anmelder: BASF SE, 67056 Ludwigshafen (DE)
(72) Erfinder: Die Erfindernennung liegt noch nicht vor

(57) **Zusammenfassung**

Die vorliegende Erfindung betrifft ein Verfahren zur Herstellung eines transparenten Polyurethankörpers, enthaltend ein oder mehrere elektronische Bauteile, bei dem man die elektronischen Bauteile in ein Polyurethelastomer einbettet und das Polyurethanelastomer zumindest teilweise mit einem transparenten Polyurethangießharz umgibt. Weiter betrifft die vorliegende Erfindung einen transparenten Formkörper, erhältlich nach einem solchen Verfahren.

## Beschreibung

Die vorliegende Erfindung betrifft ein Verfahren zur Herstellung eines transparenten Polyurethankörpers, enthaltend ein oder mehrere elektronische Bauteile, bei dem man die elektronischen Bauteile in ein Polyurethelastomer einbettet und das Polyurethanelastomer zumindest teilweise mit einem transparenten Polyurethangießharz umgibt. Weiter betrifft die vorliegende Erfindung einen transparenten Formkörper, erhältlich nach einem solchen Verfahren.

Aus Funktions- und Designgründen besteht häufig der Wunsch, elektronische Bauteile, wie beispielsweise Licht emittierende Dioden, in einen transparenten Körper einzubetten. Üblicherweise eignen sich aufgrund ihres geringen Preises und ihrer einfachen Verarbeitung transparente Kunststoffe zur Einbettung dieser Bauteile. Problematisch ist dabei aber, dass elektronische Bauteile sehr temperaturempfindlich sind und häufig bei Temperaturen von größer 100 °C zerstört werden.

Insbesondere widerstandsfähige Kunststoffe mit hoher Härte und Kratzfestigkeit können aber nur bei Temperaturen von größer 150 °C verarbeitet und in eine bestimmte Form gegeben werden. Ein einfaches Umgießen von elektronischen Bauteilen mit einem transparenten Kunststoff ist aus diesen Gründen häufig nicht möglich und würde zur Zerstörung des elektronischen Bauteils führen.

Transparente Formkörper, die ein elektronisches Bauteil enthalten, können beispielsweise erhalten werden, indem in einen zuvor hergestellten Formkörper mit Aussparung nachträglich das elektronische Bauteil eingesetzt wird. Dies hat aber den Nachteil, dass kein einheitlicher Körper vorliegt und an der Einsatzstelle beispielsweise Lichtbrechungen entstehen.

Insbesondere Polyurethane zeichnen sich durch eine hohen mechanische Stabilität und Kratzfestigkeit sowie eine einfache Verarbeitbarkeit und hohe Beständigkeit gegenüber Witterungseinflüssen aus. Allerdings bedingt die Herstellung solcher kratzfester und mechanisch stabiler Polyurethane eine hohe Vernetzungsdichte. Eine hohe Vernetzungsdichte bedeutet aber, dass auf relativ engem Raum viele Isocyanatgruppen mit gegenüber Isocyanaten reaktiven Gruppen reagieren müssen, was wiederum zu einer hohen Wärmentwicklung führt.

Aufgabe der Vorliegenden Erfindung war es daher, ein Verfahren zur Herstellung eines transparenten Formkörpers, der ein elektronisches Bauteil enthält, zu liefern, wobei das elektronische Bauteil von Polymermaterial umgeben ist, das einfach herstellbar ist und wobei der transparente Formkörper eine hohe Beständigkeit gegenüber mechanischen Einflüssen, wie Kratzbeständigkeit, sowie eine hohe Witterungsbeständigkeit aufweist.

Diese Aufgabe konnte durch ein Verfahren zur Herstellung eines transparenten Polyurethankörpers, enthaltend ein oder mehrere elektronische Bauteile, bei dem man die elektronischen Bauteile in ein transparentes Polyurethanelastomer einbettet und das Polyurethanelastomer zumindest teilweise mit einem transparenten Polyurethangießharz umgibt, gelöst werden. Weiter betrifft die vorliegende Erfindung einen transparenten Formkörper, erhältlich nach einem solchen Verfahren.

Dabei handelt es sich sowohl bei dem erfindungsgemäßen Polyurethanelastomer als auch bei dem erfindungsgemäßen Polyurethangießharz um kompakte Polyurethane. Als kompaktes Polyurethan wird ein Polyurethan bezeichnet, das im Wesentlichen frei von Gaseinschlüssen ist. Vorzugsweise ist die Dichte des kompakten Polyurethans, größer als 0,9 g/cm³, besonders bevorzugt größer 1,0 g/cm³ und insbesondere größer 1,1 g/cm³.

Transparente Polyurethane werden üblicherweise erhalten, wenn eine makroskopische Phasenseparation in Hart- und Weichsegmente vermieden wird. Dies ist dem Fachmann bekannt und kann beispielsweise durch den Verzicht auf Kettenverlängerungs- und Vernetzungsmitteln und den Einsatz vorwiegend aliphatischer Isocyanate erreicht werden.

Unter einem Polyurethanelastomer im Sinne der Erfindung wird ein Polyurethan mit gummielastischem Verhalten verstanden, das bei 20°C wiederholt mindestens auf das 1,5-Fache seiner Länge gedehnt werden kann und nach Aufhebung des für die Dehnung erforderlichen Zwanges wieder annähernd seine Ausgangsdimensionen einnimmt. Weiter weisen erfindungsgemäße Polyurethanelastomere vorzugsweise eine shore A Härte von 1 bis 20 auf. Dabei ist dem Fachmann bekannt, wie die Härte eines Polyurethanelastomers einstellabar ist. Dies kann durch Einstellung des Vernetzungsgrads und die Netzwerkdichte geschehen. Dabei spielt insbesondere die Funktionalität des Isocyanats, der Isocyanatindex und der Verzweigungsgrad sowie das Äquivalentmolekulargewicht des Polyols eine Rolle.

Vorzugsweise handelt es sich bei dem Polyurethanelastomer um ein Polyurethangel, wie beispielsweise in EP 0 057 838, EP 511 570, DE 10 138 132 oder DE 102 005 044 314 beschrieben. Der Ausdruck Gel soll dabei mehr die physikalische Beschaffenheit des gelee- oder gallertartigen Endproduktes beschreiben, als den exakten polymerphysikalischen Aufbau entsprechend den heutigen Ansichten der Kolloidchemie über diesen Zustand wiedergeben.

Die Herstellung der erfindungsgemäßen Polyurethanelastomere erfolgt dabei vorzugsweise indem man (a) organische Polyisocyanate mit (b) Polyolen, gegebenenfalls (c) Kettenverlängerungsmitteln und/oder Vernetzungsmitteln, (d) Katalysatoren und gegebenenfalls (e) sonstigen Hilfsmitteln und/oder Zusatzstoffen vermischt, in eine Form gibt und aushärtet.

Die zur Herstellung der erfindungsgemäßen Polyurethanformkörper verwendeten organischen Polyisocyanate (a) umfassen die aus dem Stand der Technik bekannten aliphatischen, cycloaliphatischen und aromatischen zwei- oder mehrwertigen Isocyanate (Bestandteil a-1) sowie beliebige Mischungen daraus. Beispiele sind 4,4'-Diphenylmethandüsocyanat, 2,4'-Diphenylmethandiisocyanat, die Mischungen aus monomeren Diphenylmethandüsocyanaten und höherkernigen Homologen des Diphenylmethandüsocyanats (Polymer-MDI), Tetramethylendiisocyanat, Hexamethylendiisocyanat (HDI), Isophorondiisocyanat (IPDI), 2,4- oder 2,6-Toluylendiisocyanat (TDI) oder Mischungen der genannten Isocyanate. Besonders bevorzugt werden als Isocyanate (a) aliphatische Isocyanate, wie Tetramethylendiisocyanat, Hexamethylendiisocyanat (HDI) und Isophorondiisocyanat (IPDI)eingesetzt.

Die Polyisocyanate (a) werden bevorzugt in Form von Polyisocyanatprepolymeren eingesetzt. Diese Polyisocyanatprepolymere sind erhältlich, indem vorstehend beschriebene Polyisocyanate (a-1) im Überschuss, beispielsweise bei Temperaturen von 30 bis 100 °C, bevorzugt bei etwa 80 °C, mit Polyolen (a-2), zum Prepolymer umgesetzt werden. Als Polyole (a-2) können beispielsweise solche wie unter (b) beschrieben eingesetzt werden.

Besonders bevorzugte Polyisocyanate (a) zur Herstellung von Polyurethanelastomeren sind biuretisiertes oder trimerisiertes 1,6-Hexamethylendüsocyanat oder Isophorondiisocyanat sowie NCO-Gruppen-haltige Anlagerungsprodukte von 1,6-Hexamethylendiisocyanat, Isophorondüsocyanat oder biuretisiertes Hexamethylendiisocyanat oder Isophorondiisocyanat an unter b) beschriebene Polyole oder an unter c) beschriebene Kettenverlängerungs- und/oder Vernetzungsmittel.

Polyole (b) mit mindestens zwei gegen Isocyanatgruppen reaktiven H-Atomen können beispielsweise Polyetherole oder Polyesterole sein.

Polyetherole werden nach bekannten Verfahren hergestellt, beispielsweise durch anionische Polymerisation mit Alkalihydroxiden oder Alkalialkoholaten als Katalysatoren und unter Zusatz mindestens eines Startermoleküls, das 2 bis 3 reaktive Wasserstoffatome gebunden enthält, oder durch kationische Polymerisation mit Lewis-Säuren, wie Antimonpentachlorid oder Borfluorid-Etherat aus einem oder mehreren Alkylenoxiden mit 2 bis 4 Kohlenstoffatomen im Alkylenrest. Geeignete Alkylenoxide sind beispielsweise Tetrahydrofuran, 1,3-Propylenoxid, 1,2- bzw. 2,3-Butylenoxid und vorzugsweise Ethylenoxid und 1,2-Propylenoxid. Weiter können als Katalysatoren auch Multimetallcyanidverbindungen, sogenannte DMC-Katalysatoren, eingesetzt werden. Die Alkylenoxide können einzeln, alternierend nacheinander oder als Mischungen verwendet werden. Bevorzugt werden Mischungen aus 1,2-Propylenoxid und Ethylenoxid verwendet, wobei das Ethylenoxid als Ethylenoxid-Endblock eingesetzt wird ("EO-cap"), so dass die entstehenden Polyole zu über 80 %, bevorzugt über 90% primäre OH-Endgruppen aufweisen.

Als Startermolekül kommen Wasser oder 2- und 3-wertige Alkohole, wie Ethylenglykol, 1,2- und 1,3-Propandiol, Diethylenglykol, Dipropylenglykol, 1,4-Butandiol, Glycerin oder Trimethylolpropan in Betracht.

Die Polyetherpolyole, vorzugsweise Polyoxypropylen-polyoxyethylen-polyole, besitzen eine Funktionalität von 2 bis 3 und zahlenmittlere Molekulargewichte von größer 500, vorzugsweise von 1000 bis 6.000 g/mol und besonders bevorzugt 1500 bis 4000 g/mol.

Polyesterpolyole können beispielsweise aus organischen Dicarbonsäuren mit 2 bis 12 Kohlenstoffatomen, vorzugsweise aliphatischen Dicarbonsäuren mit 4 bis 6 Kohlenstoffatomen, mehrwertigen Alkoholen, vorzugsweise Diolen, mit 2 bis 12 Kohlenstoffatomen, vorzugsweise 2 bis 6 Kohlenstoffatomen, hergestellt werden. Als Dicarbonsäuren kommen beispielsweise in Betracht: Bernsteinsäure, Glutarsäure, Adipinsäure, Korksäure, Azelainsäure, Sebacinsäure, Decandicarbonsäure, Maleinsäure, Fumarsäure, Phthalsäure, Isophthalsäure und Terephthalsäure. Die Dicarbonsäuren können dabei sowohl einzeln als auch im Gemisch untereinander verwendet werden. Anstelle der freien Dicarbonsäuren können auch die entsprechenden Dicarbonsäurederivate, wie z.B. Dicarbonsäureester von Alkoholen mit 1 bis 4 Kohlenstoffatomen oder Dicarbonsäureanhydride eingesetzt werden. Vorzugsweise verwendet werden Dicarbonsäuregemische aus Bernstein-, Glutar- und Adipinsäure in Mengenverhältnissen von beispielsweise 20 bis 35 : 35 bis 50 : 20 bis 32 Gew.-Teilen, und insbesondere Adipinsäure. Beispiele für zwei und mehrwertige Alkohole, insbesondere Diole sind: Ethandiol, Diethylenglykol, 1,2- bzw. 1,3-Propandiol, Dipropylenglykol, 1,4-Butandiol, 1,5-Pentandiol, 1,6-Hexandiol, 1,10-Decandiol, Glycerin und Trimethylolpropan. Vorzugsweise verwendet werden Ethandiol, Diethylenglykol, 1,4-Butandiol, 1,5-Pentandiol und 1,6-Hexandiol. Eingesetzt werden können ferner Polyesterpolyole aus Lactonen, z.B. ε-Caprolacton oder Hydroxycarbonsäuren, z.B. ω-Hydroxycapronsäure.

Zur Herstellung der Polyesterpolyole können die organischen, z.B. aromatischen und vorzugsweise aliphatischen Polycarbonsäuren und/oder -derivate und mehrwertigen Alkohole katalysatorfrei oder vorzugsweise in Gegenwart von Veresterungskatalysatoren, zweckmäßigerweise in einer Atmosphäre aus Inertgas, wie z.B. Stickstoff, Kohlenmonoxid, Helium, Argon u.a. in der Schmelze bei Temperaturen von 150 bis 250°C, vorzugsweise 180 bis 220°C, gegebenenfalls unter vermindertem Druck, bis zu der gewünschten Säurezahl, die vorzugsweise kleiner als 10 mg KOH/g, besonders bevorzugt kleiner als 2 mg KOH/g ist, polykondensiert werden.

Die erhaltenen Polyesterpolyole besitzen vorzugsweise eine Funktionalität von 2 bis 4, ein Molekulargewicht von 500 bis 3000 g/molbesonders bevorzugt 1000 bis 2500 g/mol.

Vorzugsweise werden als höhermolekulare Verbindung (b) Polyetherole mit einem Anteil an primären OH-Gruppen von mindestens 80 % eingesetzt.

Als Kettenverlängerungsmittel und/oder Vernetzungsmittel (c) werden Substanzen mit einem Molekulargewicht von vorzugsweise kleiner 500 g/mol, besonders bevorzugt von 60 bis 400 g/mol eingesetzt, wobei Kettenverlängerer 2 gegenüber Isocyanaten reaktive Wasserstoffatome und Vernetzungsmittel 3 gegenüber Isocyanat reaktive Wasserstoffatome aufweisen. Diese können einzeln oder bevorzugt in Form von Mischungen eingesetzt werden. Vorzugsweise werden Diole und/oder Triole mit Molekulargewichten kleiner als 400, besonders bevorzugt von 60 bis 300 und insbesondere 60 bis 150 eingesetzt. In Betracht kommen beispielsweise aliphatische, cycloaliphatische und/oder araliphatische Diole mit 2 bis 14, vorzugsweise 2 bis 10 Kohlenstoffatomen, wie Ethylenglykol, 1,3-Propandiol, 1,10-Decandiol, 1,2-, 1,3-, 1,4-Dihydroxycyclohexan, Diethylenglykol, Dipropylenglykol und vorzugsweise 1,4-Butandiol, 1,6-Hexandiol und Bis-(2-hydroxyethyl)-hydrochinon, Triole, wie 1,2,4-, 1,3,5-Trihydroxy-cyclohexan, Glycerin und Trimethylolpropan, und niedermolekulare hydroxylgruppenhaltige Polyalkylenoxide auf Basis Ethylen- und/oder 1,2-Propylenoxid und den vorgenannten Diolen und/oder Triolen als Startermoleküle. Besonders bevorzugt werden als Kettenverlängerer (c) Monoethylenglycol, 1,4-Butandiol und/oder Glycerin eingesetzt.

Sofern Kettenverlängerungsmittel, Vernetzungsmittel oder Mischungen davon Anwendung finden, kommen diese zweckmäßigerweise in Mengen von 1 bis 20 Gew.-%, vorzugsweise 1,5 bis 15 Gew.-% und insbesondere 2 bis 10 Gew.-%, bezogen auf das Gewicht der Komponenten (b) und (c), zum Einsatz. Bevorzugt werden keine Kettenverlängerungs- oder Vernetzungsmittel eingesetzt.

Als Katalysatoren (d) zur Herstellung der Polyurethanelastomere werden bevorzugt Verbindungen verwendet, welche die Reaktion der Hydroxylgruppen enthaltenden Verbindungen der Komponente (b) und gegebenenfalls (c) mit den organischen, gegebenenfalls modifizierten Polyisocyanaten (a) stark beschleunigen. Genannt seien beispielsweise Amidine, wie 2,3-Dimethyl-3,4,5,6-tetrahydropyrimidin, tertiäre Amine, wie Triethylamin, Tributylamin, Dimethylbenzylamin, N-Methyl-, N-Ethyl-, N-Cyclohexylmorpholin, N,N,N',N'-Tetramethylethylendiamin, N,N,N',N'-Tetramethyl-butandiamin, N,N,N',N'-Tetramethyl-hexandiamin, Pentamethyl-diethylentriamin, Tetramethyl-diaminoethylether, Bis-(dimethylaminopropyl)-harnstoff, Dimethylpiperazin, 1,2-Dimethylimidazol, 1-Aza-bicyclo-(3,3,0)-octan und vorzugsweise 1,4-Diaza-bicyclo-(2,2,2)-octan und Alkanolaminverbindungen, wie Triethanolamin, Triisopropanolamin, N-Methyl-und N-Ethyl-diethanolamin und Dimethylethanolamin. Ebenso kommen in Betracht organische Metallverbindungen, vorzugsweise organische Zinnverbindungen, wie Zinn-(II)-salze von organischen Carbonsäuren, z.B. Zinn-(II)-acetat, Zinn-(II)-octoat, Zinn-(II)-ethylhexoat und Zinn-(II)-laurat und die Dialkylzinn-(IV)-salze von organischen Carbonsäuren, z.B. Dibutyl-zinndiacetat, Dibutylzinndilaurat, Dibutylzinn-maleat und Dioctylzinn-diacetat, sowie Bismutcarboxylate, wie Bismut(III)-neodecanoat, Bismut-2-ethylhexanoat und Bismut-octanoat oder Mischungen davon. Die organischen Metallverbindungen können allein oder vorzugsweise in Kombination mit stark basischen Aminen eingesetzt werden. Handelt es sich bei der Komponente (b) um einen Ester, werden vorzugsweise ausschließlich Aminkatalysatoren eingesetzt.

Vorzugsweise verwendet werden 0,001 bis 5 Gew.-%, insbesondere 0,05 bis 2 Gew.-% Katalysator bzw. Katalysatorkombination, bezogen auf das Gewicht der Komponente (b).

Der Reaktionsmischung zur Herstellung der Polyurethanschäume können gegebenenfalls auch noch Hilfsmittel und/oder Zusatzstoffe (e) zugegeben werden. Genannt seien beispielsweise färbende Stoffe, wasserabsorbierende Substanzen, oberflächenaktive Substanzen, Flammschutzmittel, Streckmittel, Weichmacher, Metalldeaktivatoren, UV-Stabilisatoren oder Hydrolyseschutzmittel.

Als färbende Agenzien können erfindungsgemäße Gelmassen z.B. für die Einfärbung von Polyurethanen an sich bekannte Farbstoffe und/oder Farbpigmente auf organischer und/oder anorganischer Basis enthalten, beispielsweise Eisenoxid- und/oder Chromoxidpigmente und Pigmente auf Phthalocyanin- und/oder Monoazo-Basis.

Als wasserabsorbierende Substanzen kommen vorzugsweise Zeolithe in Frage.

Als oberflächenaktive Substanzen seien z.B. Cellulosepulver, Aktivkohle und Kieselsäurepräparate genannt.

Als Flammschutzmittel können beispielsweise Natrium-polymetaphosphate oder Aminphosphate, z.B. Melaminphosphate zugesetzt werden.

Als Streckmittel kommen insbesondre flüssige, praktisch inerte Substanzen infrage, die einen Siedepunkt von über 150 °C (bei Normaldruck) aufweisen. Beispielsweise seien genannt: Alkyl-, alkoxy- und/oder halogensubstituierte aromatische Verbindungen wie Dodecylbenzol, m-Dipropoxylbenzol und/oder o-Dichlorbenzol, halogenierte aliphatische Verbindungen wie chlorierte Paraffine, organische Carbonate wie Propylencarbonat, Carbonsäureester wie Dioctylphthalat sowie Dodecylsulfonsäureester und organische Phosphorverbindungen, wie Trikresylphosphat.

Als Weichmacher können alle üblicherweise für Polyurethane bekannten Stoffe eingesetzt werden, beispielsweise Ester von mehrwertigen, vorzugsweise zweiwertigen Carbonsäuren mit einwertigen Alkoholen. Außerdem kommen Ester einwertiger Alkohole mit Phosphorsäure in Frage. Weiter sind auch Alkylsulfonsäureester des Phenols, z.B. Paraffinsulfonsäurephenylester, als Weichmacher verwendbar.

Die Komponenten (a) bis (e) werden zur Herstellung eines erfindungsgemäßen Polyurethanelastomers vorzugsweise in solchen Mengen miteinander vermischt, dass der Isocyanatindex 12 bis 200, besonders bevorzugt 25 bis 100 und insbesondere 43 bis 67 beträgt.

Unter dem Isocyanatindex wird im Rahmen der vorliegenden Erfindung das stöchiometrische Verhältnis an Isocyanatgruppen zu mit Isocyanat reaktiven Gruppen, multipliziert mit 100, verstanden. Unter mit Isocyanat reaktiven Gruppen werden dabei alle in der Reaktionsmischung enthaltenen, mit Isocyanat reaktiven Gruppen, einschließlich chemischer Treibmittel, verstanden, nicht aber die Isocyanatgruppe selbst.

Im Rahmen der Erfindung wird die Mischung der Komponenten (a) bis (e) bei Reaktionsumsätzen kleiner 90 %, bezogen auf die in Minorität vorhandenen reaktiven Gruppen, als Reaktionsmischung bezeichnet.

Die erfindungsgemäßen Polyurethanelastomere werden vorzugsweise nach dem one-shot Verfahren hergestellt. Dazu werden die Komponenten (a), (b), (d) und, falls vorhanden (c) und (e), mit Hilfe der Niederdruck- oder Hochdrucktechnik in geschlossenen, zweckmäßigerweise temperierten Formwerkzeugen hergestellt. Diese Verfahrensweisen zur Herstellung von Polyurethanelastomeren sind bekannt und werden beispielsweise im "Kunststoff-Handbuch", Band 7, Polyurethane, 3. Auflage, 1993, Kapitel 8 beschrieben. Ergänzend erhält das Formwerkzeug noch das elektronische Bauteil. Dabei handelt es sich vorzugsweise um mindestens eine Licht emittierende Diode (LED).

Die Ausgangskomponenten (a) bis (e) werden dazu vorzugsweise bei einer Temperatur von 15 bis 90 °C, besonders bevorzugt von 25 bis 55 °C gemischt und die Reaktionsmischung gegebenenfalls unter erhöhtem Druck in das geschlossene Formwerkzeug eingebracht. Die Vermischung kann mechanisch mittels eines Rührers oder einer Rührschnecke oder unter hohem Druck im sogenannten Gegenstrominjektionsverfahren durchgeführt werden. Die Formwerkzeugtemperatur beträgt zweckmäßigerweise 20 bis 120 °C, vorzugsweise 30 bis 100 °C, besonders bevorzugt 30 bis 60 °C.

Der so erhaltene Formkörper aus elastomerem Polyurethan und elektronischem Bauteil kann nun in einem zweiten Schritt mit einer kratzfesten Oberfläche umgeben werden. Dazu wird der Formkörper vorzugsweise in eine zweite Form gegeben und mit einem transparenten Polyurethangießharz umgeben.

Solche transparenten Polyurethangießharzsysteme sind bekannt und werden zumeist hergestellt durch Umsetzung eines Polyols oder Polyolgemisches (B), vorzugsweise auf Basis von niedermolekularen Polyetherpolyolen, in Anwesenheit von aminischen oder metallorganischen Katalysatoren (D) in Form einer sogenannten Polyolkomponente, mit einer Isocyanatkomponente (A) und gegebenenfalls Kettenverlängerung- und Vernetzungsmitteln (C) sowie Hilfs- und Zusatzstoffen (E) erhalten.

Dabei können als Komponenten (A) bis (E) alle zuvor unter (a) bis (e) beschriebenen Verbindungen verwendet werden, wobei der Fachmann anhand ihm bekannter Parameter, wie Molekulargewicht und Funktionalität der Polyole (B), Funktionalität der Isocyanate (A), Anteil des Kettenverlängerungs- und Vernetzungsmittels (C) und des Isocyanatindex das Polyurethangießharz so einstellt, dass dies eine shore A Härte von vorzugsweise mindestens 50, weiter bevorzugt mindestens 70 noch mehr bevorzugt eine shore D Härte von 25 bis 90 und insbesondere eine shore D Härte von 30 bis 60 aufweist.

Besonders bevorzugte Polyisocyanate (A) zur Herstellung von Polyurethanelastomeren sind biuretisiertes oder trimerisiertes 1,6-Hexamethylendiisocyanat oder Isophorondiisocyanat sowie NCO-Gruppen-haltige Anlagerungsprodukte von 1,6-Hexamethylendiisocyanat, Isophorondiisocyanat oder biuretisiertes Hexamethylendiisocyanat oder Isophorondüsocyanat an unter b) beschriebene Polyole oder an unter c) beschriebene Kettenverlängerungsmittel, sogenannte Isocyanatprepolymere.

Vorzugsweise werden dabei zur Herstellung der Polyisocyanatprepolymere (A) difunktionelle Polyole eingesetzt. Das difunktionelle Polyol oder weist vorzugsweise ein mittleres Molekulargewicht von kleiner 1000 g/mol auf. Diese difunktionellen Polyole werden zumeist durch Anlagerung von niederen Alkylenoxiden, vorzugsweise Ethylenoxid, Propylenoxid oder beliebigen Mischungen dieser Alkylenoxide an difunktionelle Startsubstanzen, wie Wasser oder Diole, beispielsweise Ethylenglykol oder Propylenglykol, hergestellt. Sie können allein oder in beliebigen Mischungen untereinander eingesetzt werden. Bei Verwendung von Diolen mit einem höheren Molekulargewicht ist die Härte der resultierenden Vergußmassen üblicherweise zu gering.

In einer bevorzugten Ausführungsform der Erfindung enthält das Prepolymer neben dem Umsetzungsprodukt aus IPDI und den difunktionellen Polyolen oder Polyolgemischen noch ein trimerisiertes Isophorondüsocyanat in einer Menge von 2 Gew.-% bis von 50 Gew.-%, bezogen auf das Gesamtgewicht des Prepolymers und des trimerisierten Isophorondüsocyanats. Dabei wird das trimerisierte Isophorondüsocyanat vorzugsweise erst nach der Umsetzung von Isocyanat und Polyol zum Prepolymer diesem zugegeben. Die Trimerisierung des IPDI erfolgt üblicherweise durch den Einbau von Isocyanuratgruppen. Bei dieser Ausführungsform lässt sich die Härte der glasklaren Polyurethan-Beschichtungen erhöhen und die für die Anwendung der Beschichtungen vorteilhafte hohe Glasübergangstemperatur erreichen.

In einer besonders bevorzugten Ausgestaltung dieser Ausführungsform wird das trimerisierte Isophorondiisocyanat vor der Zugabe zu dem oben beschriebenen Isocyanatprepolymer durch partielle Umsetzung mit einem Unterschuss eines monofunktionellen Alkohols modifiziert. Durch diese Ausgestaltung wird die Löslichkeit des trimerisierten Isophorondüsocyanats verbessert und eine Kristallisation verhindert.

Das trimerisierte Isophorondüsocyanat, das gegebenenfalls mit Monoolen modifiziert ist, wird bevorzugt in einer Menge von 2 Gew.-% bis von 50 Gew.-%, bezogen auf das das Gesamtgewicht des Prepolymers und des trimerisierten Isophorondüsocyanats, eingesetzt. Die Monoole werden vorzugsweise in einer solchen Menge eingesetzt, dass der NCO-Gehalt des trimerisierten IPDI um maximal 2 Gew.-% abgesenkt wird. Bei einem zu hohen Einsatz des Monools kommt es zu einer unerwünschten Reduktion der Funktionalität der trimerisierten IPDI. Als monofunktioneller Alkohol wird vorzugsweise mindestens ein Fettalkohol mit 6 bis 25 Kohlenstoffatomen in der Hauptkette eingesetzt.

Die Herstellung der trimerisierten, das heißt durch den Einbau von Isocyanuratgruppen modifizierten aliphatischen Isocyanate, ist bekannt. Sie erfolgt üblicherweise durch katalytische Trimerisierung der Diisocyanate und nachfolgende Entfernung der nicht umgesetzten Monomere. Die Entmonomerisierung geschieht üblicherweise durch Destillation, vorzugsweise unter Vakuum und zumeist mittels eines Dünnschichtverdampfers. Die so erhaltenen Produkte, die handelsüblich sind und beispielsweise von der BASF SE unter dem Handelsnamen Basonat® Hl100 vertrieben werden, weisen zumeist einen Gehalt an monomeren Diisocyanaten von kleiner 2 Gew.-% auf.

Die Polyole (B) weisen ebenfalls üblicherweise zahlenmittlere Molekulargewichte von 2000 g/mol und weniger auf. Vorzugsweise weisen diese eine Funktionalität von mindestens 3 auf. Die bevorzugt eingesetzten Polyole (B) sind bevorzugt Polyalkylenoxyde und werden vorzugsweise ausgehend von Trimethylolpropan, Glyzerin, Pentaerythrit, Saccharose als Starter erhalten. Als Alkylenoxid wird vorzugsweise Propylenoxid eingesetzt. Bei Verwendung von Polyolen mit einem höheren Molekulargewicht ist die Härte der resultierenden Polyurethan-Vergußmassen zu gering. Weiter bevorzugt sind Polyersterole mit zahlenmittleren Molekulargewichten von kleiner 2000 g/mol, bevorzugt kleiner 1000 g/mol oder Mischungen von solchen Polyetherolen und Polyesterolen.

Als Kettenverlängerungsmittel (C), Katalysatoren (D) und Hilfs- und Zusatzstoffe (E) werden vorzugsweise die unter (c) bis (e) beschriebenen Substanzen in den dort beschriebenen Mengen eingesetzt.

Die Komponenten (A), (B) und (D) sowie gegebenenfalls (C) und (E) werden vorzugsweise bei einem Isocyanatindex von 100 bis 120, besonders bevorzugt bei 100 bis 110 umgesetzt. Die Vermischung der Komponenten sowie der Formprozess verläuft analog zur Herstellung des Polyurethanelastomers. Dabei wird eine solche Form eingesetzt, die es ermöglicht, dass die Schicht aus Polyurethangießelastomer vorzugsweise mindestens eine Dicke von 0,1 mm, besonders bevorzugt 1 mm bis 10 cm und insbesondere von 0,5 cm bis 5 cm aufweist.

Überraschenderweise weist ein erfindungsgemäßer transparenter Polyurethanformkörper eine hohe Oberflächenhärte und Kratzfestigkeit auf. Dabei kann das elektronische Bauteil zerstörungsfrei eingebaut werden und ist von Polyurethan umschlossen. Dadurch treten keine störenden optischen Effekte, wie Brechungen oder Reflektionen, auf. Handelt es sich bei dem elektronischen Bauteil um eine Leuchtdiode können die erfindungsgemäßen Polyurethanformkörper für dekorative Zwecke oder Markierungszwecke, beispielsweise als leuchtender Pflasterstein, eingesetzt werden.

Im Folgenden wird die Erfindung anhand von Beispielen verdeutlicht.

Die Platinen einer Leuchtdiode werden in einem Gießwerkzeug mit folgendem lichtechten Gelsystem umgossen:
Polyolkomponente:
   90 Gew.-Teile eines Polyoxypropylen-polyoxyethylen-polyols, ausgehend von Propylenglycol als Starter, mit einer OH-Zahl von 29 mg KOH/g
   3 Gew.-Teile eines mit Trimethylolpropan gestarteten Polyoxyethylens mit OH-Zahl von 935 mg KOH/g
   6 Gew.-Teile Dipropylenglycolmonomethylether
Katalysator: 1 Gew.-Teil einer 16 Gew.-%-igen Wismuthneodecanoat-Lösung
Isocyanatkomponente:
   Derivat auf Basis von Hexamethylendiisocyanat (HDI) mit einem NCO- Gehalt von 20 Gew-.%.

Das Mischungsverhältnis Polyolkomponente zu Isocyanatkomponente betrug 100:30 Gewichtsteile.

Die mit dem Gelsystem ummantelte Platine wird anschließend in einem anderen Gießwerkzeug fixiert und dann mit dem unten angeführten System umgossen, so dass ein Stein der Größe eines Pflastersteines mit einer Höhe von ca.10cm resultiert. Der Stein hat eine Shore D Härte von ca. 35.
Polyolkomponente:
   65 Gew.-Teile eines Polyesterols aus Adipinsäure, Butandiol, Pentandiol und Hexandiol mit einer OH-Zahl von 56 mg KOH/g
   16,5 Gew.-Teile eines Polyoxypropylenpolyols, ausgehend von Trimethylolpropan als Starter, mit einer OH-Zahl von 160 mg KOH/g
   16,5 Gew.-Teile eines Polyoxypropylenpolyols, ausgehend von Trimethylolproran als Starter, mit einer OH-Zahl von 860 mg KOH/g
   0,03 Gew.-Teile Zinnkatalysator
   4 Gew.-Teile Stabilisatormischung
Isocyanatkomponente:
   modifiziertes Hexamethylendiisocyanat (HDI) mit einem NCO-Gehalt 22.8 Gew.-%

Das Mischungsverhältnis Polyolkomponente zu Isocyanatkomponente betrug 100:100 Gewichtsteile.

Es wird ein transparenter Polyurethanformkörper mit einer shore D-Härte von 35 erhalten, der eine funktionsfähige Leuchtdiode enthält. Ein solcher Polyurethanformkörper kann für dekorative Zwecke oder Markierungszwecke, beispielsweise als leuchtender Pflasterstein eingesetzt werden.

## Patentansprüche

1. Verfahren zur Herstellung eines transparenten Polyurethankörpers, enthaltend ein oder mehrere elektronische Bauteile, bei dem man die elektronischen Bauteile in ein Polyurethelastomer einbettet und das Polyurethanelastomer zumindest teilweise mit einem transparenten Polyurethangießharz umgibt.

2. Verfahren nach Anspruch 1, **dadurch gekennzeichnet, dass** das elektronische Bauteil eine Licht emittierende Diode ist.

3. Verfahren nach Anspruch 1 oder 2, **dadurch gekennzeichnet, dass** das Polyurethanelastomer eine shore A Härte von 1 bis 20 aufweist.

4. Verfahren nach einem der Ansprüche 1 bis 3, **dadurch gekennzeichnet, dass** als Isocyanat (a) zur Herstellung des Polyurethanelastomers ein aliphatisches Isocyanat eingesetzt wird.

5. Verfahren nach einem der Ansprüche 1 bis 4, **dadurch gekennzeichnet, dass** das transparente Polyurethangießharz erhalten wird durch Vermischen von Isocyanaten, enthaltend trimerisiertes Isophorondüsocyanat und/oder Hexamethylendiisocyanat, und Polyolen, enthaltend Polyalkylenoxydpolyole mit einer Funktionalität von mindestens 3 und einem Molekulargewicht von höchstens 2000 g/mol.

6. Verfahren nach einem der Ansprüche 1 bis 5, **dadurch gekennzeichnet, dass** das Polyurethangießharz eine Dicke von mindestens 0,1 mm aufweist.

7. Transparenter Formkörper, erhältlich nach einem Verfahren gemäß einem der Ansprüche 1 bis 5.
